# EUROPEAN PATENT APPLICATION

(11) **EP 3 955 289 A1**
(43) Date of publication of application: **16.02.2022**
(21) Application number: 20190539.5
(22) Date of filing: 11.08.2020
(51) Int. Cl.: H01L 23/49, H01L 23/492, H01L 23/495

(54) **FOUR TERMINAL TRANSISTOR PACKAGE**

(71) Applicant: Infineon Technologies Austria AG, 9500 Villach (AT)
(72) Inventor: OTREMBA, Ralf, 87600 Kaufbeuren (DE); KUTSCHAK, Matteo-Alessandro, 9072 Ludmannsdorf (AT); RIEGLER, Andreas, 9241 Lichtpold (AT); WEBER, Hans, 83457 Bayerisch Gmain (DE)
(74) Representative: Lambsdorff & Lange Patentanwälte Partnerschaft mbB

(57) **Abstract**

A transistor package having four terminals comprises a semiconductor transistor chip (120) and a semiconductor diode chip (140). The semiconductor transistor chip (120) comprises a control electrode (122) and a first load electrode (124) on a first surface (120A) and a second load electrode on a second surface opposite the first surface (120A). The semiconductor diode chip (140) comprises a first diode electrode (144) on a first surface (140A) and a second diode electrode on a second surface opposite the first surface (140A). The transistor package comprises a first terminal (150) electrically coupled to the control electrode (122), a second terminal (160) electrically coupled to the first diode electrode (144), a third terminal (170) electrically coupled to the first load electrode (124) and a fourth terminal (180) electrically coupled to the second load electrode. At least the first terminal (150), the second terminal (160) and the third terminal (170) are aligned at one side of transistor package. The first terminal (150) is arranged between the second terminal (160) and the third terminal (170).

## Description

### Technical Field

This disclosure relates generally to the technique of semiconductor packaging, and in particular to a transistor package having four terminals.

### Background

Transistor packages are widely used as electronic switches in a variety of electronic circuits. Higher efficiency, increased power density, lower switching losses and lower cost are among the key goals for next generation transistor package design. A conventional approach to reduce switching losses is to use a four pin package instead of a three pin package, wherein the fourth pin is a Kelvin sense pin. The Kelvin sense pin allows removal of the influence of a load pin inductance on the connection to the control electrode of the transistor. The Kelvin sense pin, when connected to a driver IC (integrated circuit), can reduce switching losses by about 20% and more.

### Summary

According to an aspect of the disclosure, a transistor package having four terminals comprises a semiconductor transistor chip and a semiconductor diode chip. The semiconductor transistor chip comprises a control electrode and a first load electrode on a first surface and a second load electrode on a second surface opposite the first surface. The semiconductor diode chip comprises a first diode electrode on a first surface and a second diode electrode on a second surface opposite the first surface. The transistor package comprises a first terminal electrically coupled to the control electrode, a second terminal electrically coupled to the first diode electrode, a third terminal electrically coupled to the first load electrode and a fourth terminal electrically coupled to the second load electrode. At least the first terminal, the second terminal and the third terminal are aligned at one side of transistor package. The first terminal is arranged between the second terminal and the third terminal.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1 is a schematic top view on an example of a transistor package.
Figure 2 is a schematic top view on a first embodiment of a transistor package shown without the encapsulant.
Figure 3A is a schematic cross-sectional view of the transistor package of Figure 2 along line A-A'.
Figure 3B is a schematic cross-sectional view of the transistor package of Figure 2 along line B-B'.
Figure 4 is a perspective view of the transistor package of Figures 2 and 3.
Figure 5 is a schematic top view of a second embodiment of a transistor package shown without the encapsulant.
Figure 6 is a perspective view on the top side of the transistor package of Figure 5.
Figure 7 is a perspective view on the backside of the transistor package of Figures 5 and 6.
Figure 8 is a perspective top view of a third embodiment of a transistor package shown without the encapsulant.
Figure 9 is a perspective view on the top side of the transistor package of Figure 8.
Figure 10 is a perspective view on the backside of the transistor package of Figures 8 and 9.
Figure 11 is an electrical schematic of an exemplary semiconductor transistor package containing a Si semiconductor diode chip.
Figure 12 is an electrical schematic of an exemplary semiconductor transistor package containing a SiC semiconductor diode chip.

### Detailed description

It is to be understood that the features of the various exemplary embodiments and examples described herein may be combined with each other unless specifically noted otherwise.

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

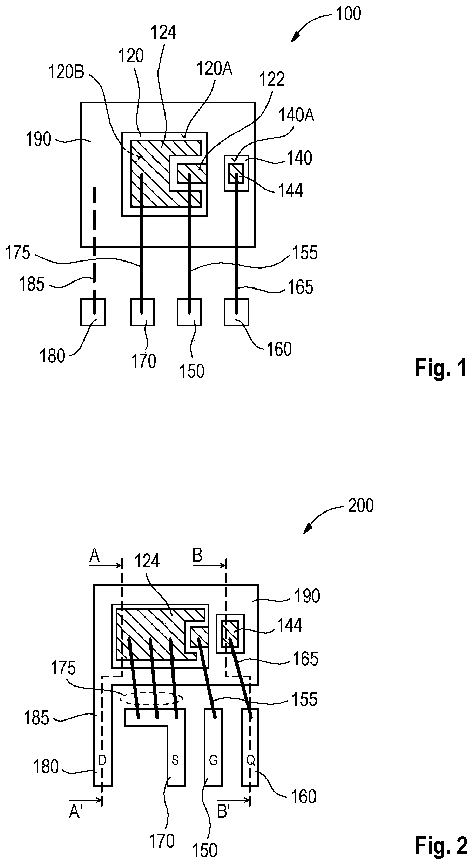

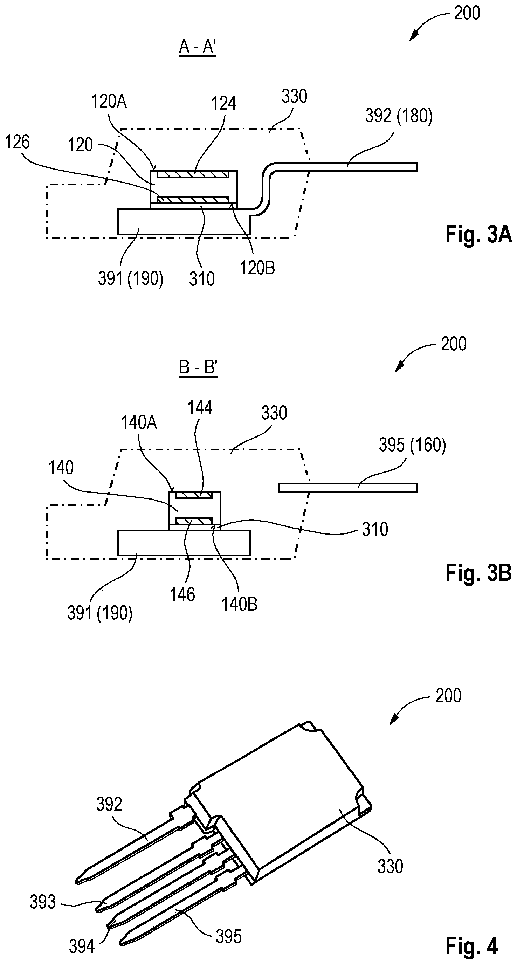

Referring to Figure 1, a transistor package 100 includes a semiconductor transistor chip 120 and a semiconductor diode chip 140. The semiconductor transistor chip 120 has a first surface 120A on which a control electrode 122 and a first load electrode 124 are located. The first surface 120A may be the top surface of the semiconductor transistor chip 120. The semiconductor transistor chip 120 has a second surface 120B (see also Figure 3A) opposite the first surface 120A. A second load electrode 126 is located on the second surface 126 of the semiconductor transistor chip 120.

Further, the transistor package 100 includes a semiconductor diode chip 140. The semiconductor diode chip 140 has a first diode electrode 144 on a first surface 140A and a second diode electrode 146 (see Figure 3B) on a second surface 140B opposite the first surface 140A.

The transistor package 100 includes a first terminal 150 electrically coupled to the control electrode 122, a second terminal 160 electrically coupled to the first diode electrode 144, a third terminal 170 electrically coupled to the first load electrode 124 and a fourth terminal 180 electrically coupled to the second load electrode 126. At least the first terminal 150, the second terminal 160 and the third terminal 170 are aligned at (and may, e.g., protrude from) one side of transistor package 100. The first terminal 150 is arranged between the second terminal 160 and the third terminal 170. All terminals 150, 160, 170, 180 are package terminals, i.e. are configured to electrically connect the transistor package 100 to external circuitry such as, e.g. an application board (not shown).

As will be described in greater detail further below, a variety of different interconnects may be used for coupling the electrodes 144, 122, 124, 126 to the terminals 160, 150, 170, 180, respectively. Figure 1 illustrates a first electrical conductor 155 electrically coupling the control electrode 122 to the first terminal 150, a second electrical conductor 165 electrically coupling the first diode electrode 144 to the second terminal 160, a third electrical conductor 175 electrically coupling the first load electrode 124 to the third terminal 170 and a fourth electrical conductor 185 (which may, e.g., include the carrier 190) electrically coupling the second load electrode 126 to the fourth terminal 180.

The four terminals 150, 160, 170, 180 are the sole package terminals, that is only four terminal transistor packages 100 are considered herein.

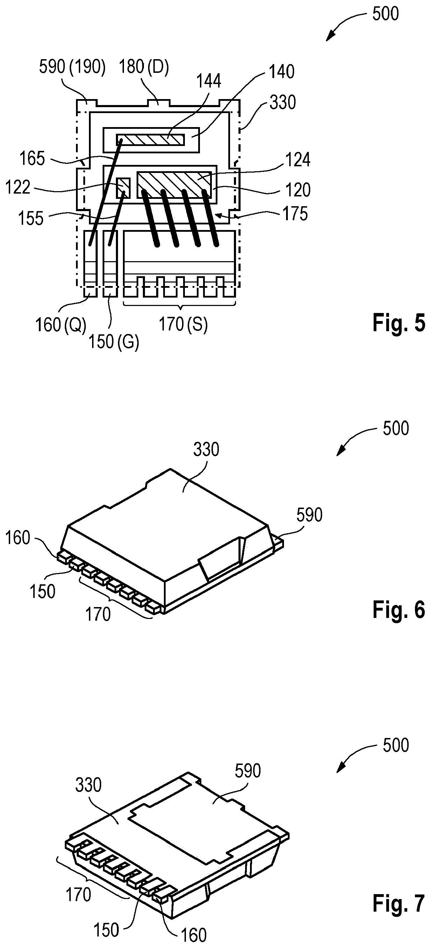

In Figure 1, the fourth terminal 180 is - by way of example - shown to be aligned at (and, e.g. to protrude from) the same side of the transistor package 100 as the first, second and third terminals 150, 160, 170. Other possibilities of arranging the fourth terminal 180 will be described further below in conjunction with Figures 5 to 10.

According to one embodiment, the terminals 150, 160, 170, 180 may be leads of a leaded transistor package. According to other embodiments, the terminals 150, 160, 170, 180 may be pins or bottom side contact areas (often referred to as lands) of a leadless transistor package, e.g. of an SMD (surface mounted device) transistor package.

The semiconductor package 100 may include an encapsulant (not shown in Figure 1). For instance, a molding process may be carried out to encapsulate the semiconductor chips 120, 140 arranged on the carrier 190 with a mold material (see, e.g., Figures 4, 6, 7, 9, 10).

The semiconductor transistor chip 120 may be placed over a carrier 190 with its second surface 120B facing the carrier 190. Likewise, the semiconductor diode chip 140 may be placed over the carrier 190 with its second surface 140B facing the carrier 190. That is, the carrier 190 may e.g. be a common carrier on which both semiconductor chips 120, 140 are mounted.

The carrier 190 may be a carrier having a high thermal conductivity. The carrier 190 may, e.g., be a leadframe or a metal bonded ceramic carrier such as, e.g., a DCB (direct copper bond) carrier or a CPC (copper plated ceramic) carrier.

A ceramic carrier may, e.g., be made of Al₂O₃ or AlN or any other suitable ceramic. A leadframe may be manufactured from metal or metal alloys, in particular copper, copper alloys, iron nickel, aluminum, aluminum alloys, or other electrically conductive materials. Furthermore, the leadframe may be plated with an electrically conductive material, for example copper, silver, iron nickel or nickel phosphorus. The leadframe may have been manufactured by punching a metal plate.

The semiconductor transistor chip 120 may be configured as a power semiconductor chip. Power semiconductor chips are suitable, in particular, for the switching high currents and/or high voltages (e.g. more than 100 V or 300 V or 500 V blocking voltage). The semiconductor transistor chip 120 may be of different types, e.g. MOSFET (Metal Oxide Semiconductor Field Effect Transistor), in particular an SJ (super junction)-MOSFET, HEMT (High Electron Mobility Transistor), JFET (Junction Gate Field Effect Transistor), IGBT (Insulated Gate Bipolar Transistor), or bipolar transistor.

The semiconductor transistor chip 120 may have a vertical structure, i.e. the electrical load current may flow in a direction perpendicular to the first and second surfaces 120A, 120B of the semiconductor transistor chip 120 from one load electrode 124, 126 to the other load electrode 126, 124. By way of example and without loss of generality, the first load electrode 124 may be the source electrode (or emitter electrode in case of an IGBT or a bipolar transistor) and the control electrode 122 may be the gate electrode (or base electrode in case of a bipolar transistor) of the semiconductor transistor chip 120, while the second load electrode 126 may be the drain electrode (or collector electrode in case of an IGBT or a bipolar transistor) of the semiconductor transistor chip 120. However, it is also possible that the first loud electrode 124 may be the drain electrode (or collector electrode) and the second load electrode 126 may be the source electrode (or emitter electrode).

The semiconductor transistor chip 120 may be fabricated from specific semiconductor material, for example Si, SiC, GaN, SiGe, GaAs, etc. In particular, the semiconductor transistor chip 120 may be made of a WBG (Wide Bandgap) semiconductor material such as, e.g., SiC, GaN, and many III-V and II-VI compound semiconductors having a high bandgap.

The semiconductor diode chip 140 may be placed over the carrier 190 with its second surface 140B facing the carrier 190. The semiconductor diode chip 140 may be configured to temporarily carry a load current switched by the semiconductor transistor chip 120. The semiconductor diode chip 140 may have a vertical structure, i.e. the electrical load current may flow in a direction perpendicular to the first and second surfaces 140A, 140B of the semiconductor diode chip 140. By way of example and without loss of generality, the first diode electrode 144 may be the anode and the second diode electrode 146 may be the cathode of the diode. However, depending on the load electrode arrangement of the semiconductor transistor chip 120, it is also possible that the first diode electrode 144 could be the cathode and the second diode electrode 146 could be the anode of the diode.

The semiconductor diode chip 140 may be fabricated from specific semiconductor material, for example SiC, GaN, SiGe, GaAs, etc. In particular, the semiconductor diode chip 140 may be made of a WBG (Wide Bandgap) semiconductor material such as, e.g., SiC, GaN, and many III-V and II-VI compound semiconductors having a high bandgap.

Figures 2, 3A-3B and 4 illustrate views of a transistor package 200 of a first embodiment. The transistor package 200 is designed in accordance with the features described for transistor package 100 in conjunction with Figure 1. Therefore, reference is made to the above disclosure in order to avoid reiteration.

Transistor package 200 illustrates an example in which all four terminals 150, 160, 170, 180 are aligned at and protrude from one side of the transistor package 200. In the example shown, the order from right to left is second terminal 160, first terminal 150, third terminal 170 and fourth terminal 180. This order may correspond with a terminal assignment (from right to left) by Q, G, S, and D. Q denotes the anode of the semiconductor diode chip 140 and G, S and D denote the gate, source and drain electrodes of the semiconductor transistor chip 120. As mentioned previously, depending on the type of the semiconductor transistor chip 120 used, G, S and D may translate into B (base), E (emitter) and C (collector), respectively. Without loss of generality and for the sake of brevity, in the following the terminal assignment Q, G, S and D will be used as an example.

In Figure 2 the first, second, third and fourth terminals 150, 160, 170 and 180 are each designed as leads. That is, transistor package 200 exemplifies a leaded semiconductor package configured to be mounted to an application board, e.g., a PCB (printed circuit board) by inserting, for example, the leads into drilled holes in the application board and, e.g., by wave soldering.

Further, Figure 2 and Figure 3A illustrate that the fourth terminal 180 may be contiguous with the carrier 190. The carrier 190 may be a leadframe comprising a chip pad 391 and a lead 392 integrally formed with the chip pad 391. In this case, the lead 392 represents the fourth terminal 180 of the transistor package 200.

In one example the four terminals 150, 160, 170, 180 may all be spaced apart from each other by the same distance. In another example the first, second and third terminals (e.g. leads) 150, 160, 170 may be spaced apart from each other by the same distance, while the fourth terminal (e.g. lead) 180 is spaced apart from the neighboring terminal (lead), here the third terminal 170, by a distance greater than the distance between the first, second and third terminals (leads) 150, 160, 170.

Figure 3B illustrates that a lead 395, which represents the second terminal 160, may be on the same level as lead 392 (which represents the fourth terminal 180). More specifically, all leads 392, 393, 394, 395 (see Figure 4) may protrude from the semiconductor package 200 at the same side and at the same level.

In one example the transistor package 200 may be a TO (transistor outline) package. TO packages are available in different sizes and designs. For instance, the transistor package 200 may be a variant of the conventional TO-247 4pin package marketed by Infineon^{®}. The conventional TO-247 4pin package is a four terminal package accommodating a semiconductor transistor chip. However, this conventional package TO-247 4pin does not accommodate a semiconductor diode chip as disclosed herein. Further, the terminal assignment of the conventional TO-247 4pin package is different from the terminal assignment disclosed herein. More specifically, the conventional TO-247 4pin package has an extra Kelvin sense terminal (also referred to as driver source terminal) which bypasses the lead inductance at the third terminal 170 on the gate control loop. That is, in the conventional TO-247 4pin transistor package the first terminal 150 is the Kelvin sense terminal (instead of the control electrode terminal as disclosed herein) and the second terminal 160 is the control electrode terminal (instead of the first diode electrode terminal, as disclosed herein). And still further, the transistor package 200 as disclosed herein does not contain a Kelvin sense terminal configured to be connected to a driver circuit but instead the second terminal 160 connected to the first diode electrode 144 and being configured to temporarily carry a load current switched by the semiconductor transistor chip 120.

Differently put, the leadframe (i.e. carrier 190) and an (optional) encapsulant 330 (see Figures 3A, 3B, 4) as well as molding equipment to manufacture the transistor package 200 may be the same as the leadframe, the encapsulant and molding equipment used for producing the conventional TO-247 4pin semiconductor package. This "reuse" of existing equipment greatly reduces the cost of the transistor package 200 as disclosed herein. On the other hand, as a result of the integration of the semiconductor diode chip 140 and the change and reassignment of the package terminals, the transistor package 200 in accordance with the disclosure can outperform the conventional TO-247 4pin package in terms of decreased switching losses.

In transistor package 200 and in all other transistor package embodiments disclosed herein, the semiconductor transistor chip 120 and/or the semiconductor diode chip 140 may be mounted to the carrier 190 (e.g. the chip pad 391) by diffusion soldering. Diffusion soldering allows to obtain the smallest possible free distance or gap between the semiconductor transistor chip 120 and the semiconductor diode chip 140. As space is limited in the transistor package 200 (in particular, if the conventional TO-247 4pin package is to be reused), diffusion soldering may be beneficial.

In other examples the semiconductor transistor chip 120 and/or the semiconductor diode chip 140 may be mounted to the carrier 190 (e.g. chip pad 391) by soft solder or a bonding paste or an electrically conductive adhesive or a sinter bond. These bond materials are indicated in Figures 3A and 3B by reference sign 310.

In this and all other embodiments disclosed herein, the first electrical conductor 155 and the second electrical conductor 165 may be aluminum wires and/or may have the same thickness (e.g. diameter). Using the same material and/or the same thickness for wires used as the first and second electrical conductors 155, 165 may reduce manufacturing costs. Alternatively, the second electrical conductor 165 (e.g. wire) may have a thickness (e.g. diameter) greater than the thickness (e.g. diameter) of the first electrical conductor 155 (e.g. wire).

In this and all other embodiments disclosed herein, the first electrical conductor 155 may be a wire and the third electrical conductor 175 may be a clip or a ribbon. The clip or ribbon used as the third electrical conductor 175 provides for a high current capacity. In this case, the second electrical conductor 165 may either be a wire (e.g. of the same material and thickness as the wire used for the first electrical conductor 155) or may be a clip or a ribbon (e.g. the same clip or ribbon as used for the third electrical conductor 175). Hence, the electrical interconnect can be realized in a cost-effective manner, since only at most two different types of electrical conductors are used.

In this and all other embodiments described herein, the second terminal 160 can be configured to have a temporary current carrying capacity equal to or greater than a current carrying capacity of the third terminal 170. As mentioned before, the semiconductor diode 140 carries for a short time (e.g. equal to or less than 1 % of the total time) the load current. The second terminal 160 is therefore a "temporary" load current terminal. It can therefore virtually be understood as a "second" first load electrode terminal (e.g. second source terminal) or a "spare" first load electrode terminal (e.g. a spare source terminal).

If the second electrical conductor 165 is implemented by a clip or a ribbon, the high current capacity required at the second terminal 160 can be managed. On the other hand, if the second electrical conductor 165 is a wire, the wire may have a diameter equal to or greater than 125 µm. In this case, the diameter of the wire of the first electrical conductor 155 may also be 125 µm or more, even though a wire having a smaller diameter (e.g. 75 µm) would be sufficient for the first electrical conductor 155.

Figures 5 to 7 illustrate a second embodiment of a transistor package 500. The transistor package 500 is designed in accordance with the transistor package 100 and partly in accordance with the transistor package 200 and therefore, reference is made to the above description in order to avoid reiteration.

The transistor package 500 may also be a TO package. However, in contrast to transistor package 200, the transistor package 500 is a leadless package to enable an SMD approach for high current switching.

In transistor package 500 the fourth terminal 180 is a bottom terminal implemented by a carrier plate 590. The carrier plate 590 is exposed at the bottom side of the transistor package 500, see Figure 7. Further, in contrast to the design of the transistor package 200, the fourth terminal 180 may be aligned at and, e.g., protrude from a side opposite the side from which the first, second and third terminals 150, 160, 170 protrude. The first, second and third terminals 150, 160, 170 are implemented by metal pins in this example. While the first and second terminals 150, 160 may each be implemented by one pin, the third terminal 170 may be implemented by a number pins, e.g. by 6 pins arranged in a row as depicted in Figures 5 to 7.

The semiconductor transistor chip 120 and the semiconductor die chip 140 may be mounted on the carrier plate 590 the same way as described above. Further, the electrical conductors 155, 165, 175 may be implemented in accordance with the options disclosed above. In the example shown in Figure 5, the third electrical conductor 175 is, e.g., implemented by four copper ribbons, while the first and second electrical conductors 155, 165 are implemented by wires, e.g. aluminum wires.

Again, the first terminal 150 is not an edge terminal of the transistor package 500 but is located between the second terminal 160 and the third terminal 170. This, inter alia, distinguishes the transistor package 500 from a conventional transistor package of Infineon^{®}, which is known as TOLL (transistor outline leadless) package in the art. The conventional TOLL package only contains the transistor chip 120 but not the semiconductor diode chip 140. Further, similar to the description above regarding the conventional TO-247 4pin package, the terminal assignment of the transistor package 500 is different from the terminal assignment in the conventional TOLL package. More specifically, in the conventional TOLL package the first terminal 150 is a Kelvin sense terminal (rather than a control electrode terminal as disclosed herein) and the second terminal 160 is the control electrode terminal (rather than the first diode electrode terminal as disclosed herein). Nevertheless, analogously to the description above for the conventional package TO-247 4pin, the conventional TOLL package can be "reused" in terms of the carrier, the encapsulant and the equipment for molding the encapsulant.

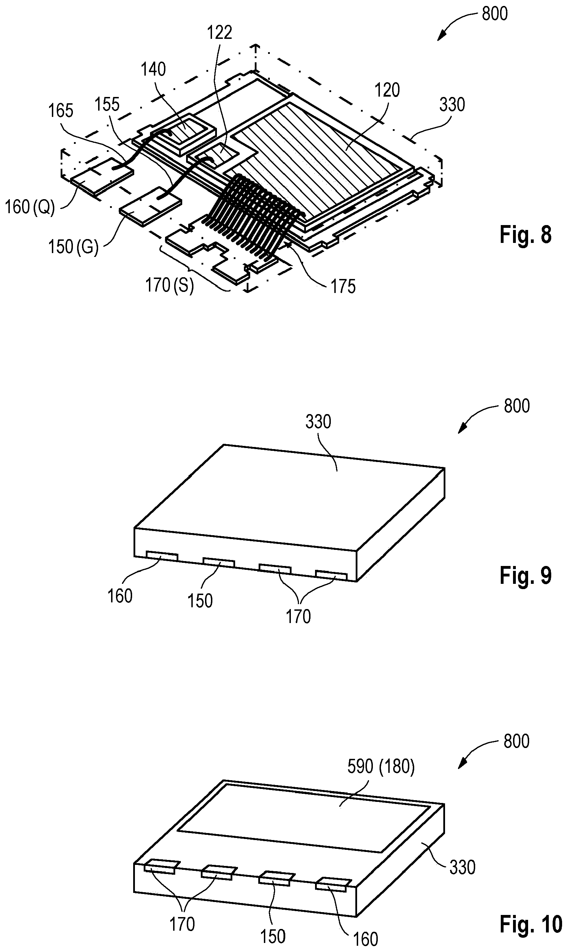

Figures 8 to 10 illustrate a third embodiment of a transistor package 800. The transistor package 500 is designed in accordance with the transistor package 100 and partly in accordance with the transistor packages 200, 500 and therefore, reference is made to the above description in order to avoid reiteration.

The transistor package 800 is -similar to transistor package 500 - a leadless package to enable an SMD approach for high current switching.

The first, second and third terminals 150, 160, 170 are implemented by bottom side contact areas (lands) exposed at the bottom side of the transistor package 800, see Figure 10. The first, second and third terminals 150, 160, 170 may also be exposed at the one side of the transistor package at which they are arranged, but may not protrude from the encapsulant 330 as pins (transistor package 500) or leads (transistor package 200).

Further, in transistor package 800 the fourth terminal 180 is a bottom terminal implemented by a carrier plate 590. Similar to transistor package 500, the carrier plate 590 is exposed at the bottom side of the transistor package 800, see Figure 10. In transistor package 800, however, the fourth terminal 180 may not be exposed at a side opposite the side at which the first, second and third terminals 150, 160, 170 are arranged in contrast to the design of the transistor package 500.

The semiconductor transistor chip 120 and the semiconductor die chip 140 may be mounted on the carrier plate 590 the same way as described above. Further, the electrical conductors 155, 165, 175 may be implemented in accordance with the options disclosed above. In the example shown in Figure 8, all electrical conductors 155, 165, 175 are implemented by wires.

Again, the first terminal 150 is not an edge terminal of the transistor package 800 but is located between the second terminal 160 and the third terminal 170. This, inter alia, distinguishes the transistor package 800 from a conventional transistor package of Infineon^{®}, which is known as ThinPAK 8x8 in the art. The conventional ThinPAK 8×8 package only contains the transistor chip 120 but not the semiconductor diode chip 140. Further, similar to the description above regarding the conventional TO-247 4pin package and the conventional TOLL package, the terminal assignment of the transistor package 800 is different from the terminal assignment in the conventional ThinPAK 8×8 package. More specifically, in the conventional ThinPAK 8×8 package the first terminal 150 is a Kelvin sense terminal (rather than a control electrode terminal as disclosed herein) and the second terminal 160 is the control electrode terminal (rather than the first diode electrode terminal as disclosed herein). Nevertheless, analogously to the description above for the conventional package TO-247 4pin and the conventional TOLL package, conventional ThinPAK 8×8 package can be "reused" in terms of the carrier, the encapsulant and the equipment for molding the encapsulant. The transistor package 800 may be very small (e.g. 64 mm² footprint area and 1 mm height) and offers low parasitic inductances.

Stated differently, in one example, the perspective views of Figures 4, 6, 7, 9 and 10 may, e.g., be identical to the corresponding conventional packages while the terminal assignment and the semiconductor equipment (semiconductor transistor chip 120 and semiconductor diode chip 140) are not.

Due to the new concept of package terminal assignment described herein, all transistor packages 100, 200, 500, 800 can avoid electrical connector crossing. In all transistor packages 100, 200, 500, 800 the semiconductor diode chip 140 may be used to improve switching behavior of the transistor package. More specifically, during the switching event the semiconductor transistor chip 120 is removed from the load current circuit and the load current is coupled to the semiconductor diode chip 140. As a result, the switching losses can be greatly reduced.

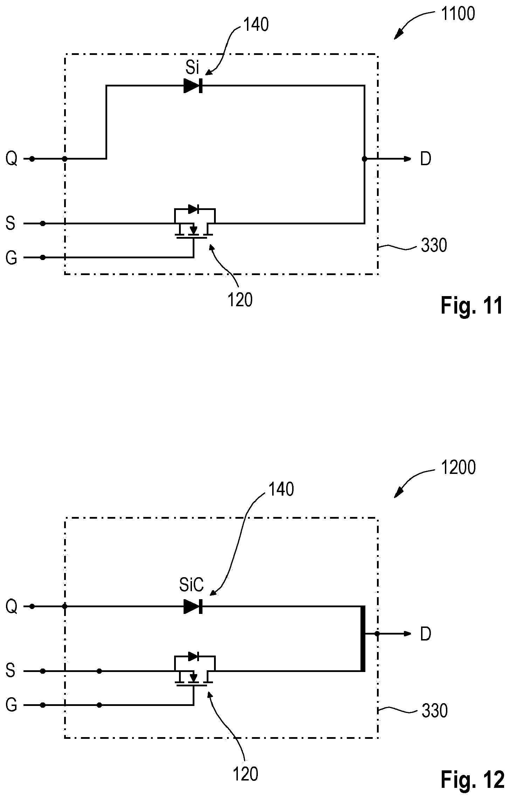

Figures 11 and 12 illustrate two electrical schematics of the exemplary semiconductor transistor packages 100, 200, 500, 800. In Figure 11 the semiconductor diode chip 140 is implemented by, e.g., a Si diode. The semiconductor transistor chip 120 is implemented by, e.g., an SJ-MOSFET or, more specifically, for instance an n-channel enhancement mode SJ-MOSFET. The electrical schematic of Figure 12 distinguishes from the electrical schematic of Figure 11 in that the semiconductor diode chip 140 is implemented by a SiC diode, i.e. a wide bandgap diode.

In the case of the schematic of Figure 11, frequencies of about 5 kHz to 30 kHz can be switched. Possible applications are half-bridge circuits as, e.g., used in motor drives.

If a wide bandgap semiconductor diode chip 140 is used, the switching frequencies may be equal to or greater than 50 kHz. For instance, typical switching frequencies are 65 kHz or 130 kHz or even greater. Possible applications are power factor correction (PFC) circuits. In these circuits the transistor package 100, 200, 500, 800 may also be part of a half-bridge circuit.

### EXAMPLES

The following examples pertain to further aspects of the disclosure:
Example 1 is a transistor package, comprising: transistor package having four terminals, comprising: a semiconductor transistor chip comprising a control electrode and a first load electrode on a first surface and a second load electrode on a second surface opposite the first surface; a semiconductor diode chip comprising a first diode electrode on a first surface and a second diode electrode on a second surface opposite the first surface; a first terminal electrically coupled to the control electrode; a second terminal electrically coupled to the first diode electrode; a third terminal electrically coupled to the first load electrode; and a fourth terminal electrically coupled to the second load electrode, wherein at least the first terminal, the second terminal and the third terminal are aligned at one side of transistor package, and the first terminal is arranged between the second terminal and the third terminal.
In Example 2, the subject matter of Example 1 can optionally include wherein the fourth terminal is aligned at the one side of the transistor package.
In Example 3, the subject matter of Example 1 or 2 can optionally include wherein the first terminal, the second terminal, the third terminal and the fourth terminal are leads.
In Example 4, the subject matter of Example 1 can optionally include wherein the fourth terminal is a bottom terminal of the transistor package and/or is aligned at a side opposite the one side of the transistor package.
In Example 5, the subject matter of Example 4 can optionally include wherein the transistor package is a leadless package.
In Example 6, the subject matter of any preceding Example can optionally include wherein the semiconductor transistor chip is placed over a carrier with its second surface facing the carrier.
In Example 7, the subject matter of Example 6 can optionally include wherein the semiconductor diode chip is placed over the carrier with its second surface facing the carrier.
In Example 8, the subject matter of Example 6 or 7 can optionally include wherein the fourth terminal is contiguous with the carrier.
In Example 9, the subject matter of Example 7 or 8 can optionally include wherein the semiconductor transistor chip and/or the semiconductor diode chip are mounted to the carrier by diffusion soldering.
In Example 10, the subject matter of any of the preceding Examples can optionally include wherein the semiconductor diode chip is configured to temporarily carry a load current switched by the semiconductor transistor chip.
In Example 11, the subject matter of any of the preceding Examples can optionally include wherein a first wire electrically couples the control electrode to the first terminal, a second wire electrically couples the first diode electrode to the second terminal, and the first wire and the second wire are aluminum wires.
In Example 12, the subject matter of any of the preceding Examples can optionally include wherein a first wire electrically couples the control electrode to the first terminal, a second wire electrically couples the first diode electrode to the second terminal, and the first wire and the second wire have the same thickness.
In Example 13, the subject matter of any of Examples 1 to 10 can optionally include wherein a first wire electrically couples the control electrode to the first terminal, a clip or ribbon electrically couples the first load electrode to the third terminal, and a second wire electrically couples the first diode electrode to the second terminal or a clip or ribbon electrically couples the first diode electrode to the second terminal.
In Example 14, the subject matter of any of the preceding Examples can optionally include wherein the second terminal is configured to have a temporary current carrying capacity equal to or greater than a current carrying capacity of the third terminal
In Example 15, the subject matter of any of the preceding Examples can optionally include wherein the semiconductor transistor chip comprises a superjunction MOSFET transistor or a high-electron-mobility transistor or a wide bandgap transistor.
In Example 16, the subject matter of any of the preceding Examples can optionally include wherein the semiconductor diode chip comprises a Si diode or a wide bandgap diode or a SiC diode.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A transistor package having four terminals, comprising:
a semiconductor transistor chip comprising a control electrode and a first load electrode on a first surface and a second load electrode on a second surface opposite the first surface;
a semiconductor diode chip comprising a first diode electrode on a first surface and a second diode electrode on a second surface opposite the first surface;
a first terminal electrically coupled to the control electrode;
a second terminal electrically coupled to the first diode electrode;
a third terminal electrically coupled to the first load electrode; and
a fourth terminal electrically coupled to the second load electrode, wherein
at least the first terminal, the second terminal and the third terminal are aligned at one side of transistor package, and
the first terminal is arranged between the second terminal and the third terminal.

2. The transistor package of claim 1, wherein the fourth terminal is aligned at the one side of the transistor package.

3. The transistor package of claim 1 or 2, wherein the first terminal, the second terminal, the third terminal and the fourth terminal are leads.

4. The transistor package of claim 1, wherein the fourth terminal is a bottom terminal of the transistor package and/or is aligned at a side opposite the one side of the transistor package.

5. The transistor package of claim 4, wherein the transistor package is a leadless package.

6. The transistor package of any of the preceding claims, wherein the semiconductor transistor chip is placed over a carrier with its second surface facing the carrier.

7. The transistor package of claim 6, wherein the semiconductor diode chip is placed over the carrier with its second surface facing the carrier.

8. The transistor package of claim 6 or 7, wherein the fourth terminal is contiguous with the carrier.

9. The transistor package of claim 7 or 8, wherein the semiconductor transistor chip and/or the semiconductor diode chip are mounted to the carrier by diffusion soldering.

10. The transistor package of any of the preceding claims, wherein the semiconductor diode chip is configured to temporarily carry a load current switched by the semiconductor transistor chip.

11. The transistor package of any of the preceding claims, wherein
a first wire electrically couples the control electrode to the first terminal,
a second wire electrically couples the first diode electrode to the second terminal, and
the first wire and the second wire are aluminum wires.

12. The transistor package of any of the preceding claims, wherein
a first wire electrically couples the control electrode to the first terminal,
a second wire electrically couples the first diode electrode to the second terminal, and
the first wire and the second wire have the same thickness.

13. The transistor package of any of claims 1 to 10, wherein
a first wire electrically couples the control electrode to the first terminal,
a clip or ribbon electrically couples the first load electrode to the third terminal, and
a second wire electrically couples the first diode electrode to the second terminal or a clip or ribbon electrically couples the first diode electrode to the second terminal.

14. The transistor package of any of the preceding claims, wherein the second terminal is configured to have a temporary current carrying capacity equal to or greater than a current carrying capacity of the third terminal.

15. The transistor package of any of the preceding claims, wherein the semiconductor transistor chip comprises a superjunction MOSFET transistor or a high-electron-mobility transistor or a wide bandgap transistor.

16. The transistor package of any of the preceding claims, wherein the semiconductor diode chip comprises a Si diode or a wide bandgap diode or a SiC diode.
